(19) Europäisches Patentamt / European Patent Office / Office européen des brevets

(11) **EP 4 734 180 A1**

(12) **EUROPEAN PATENT APPLICATION**
published in accordance with Art. 153(4) EPC

(43) Date of publication:
**29.04.2026 Bulletin 2026/18**

(21) Application number: **24845911.7**

(22) Date of filing: **17.07.2024**

(51) International Patent Classification (IPC):
$H01M\ 4/505^{(2010.01)}$ $H01M\ 4/525^{(2010.01)}$
$H01M\ 10/052^{(2010.01)}$ $H01M\ 4/02^{(2006.01)}$

(52) Cooperative Patent Classification (CPC):
**H01M 4/02; H01M 4/505; H01M 4/525;
H01M 10/052; Y02E 60/10**

(86) International application number:
**PCT/KR2024/010272**

(87) International publication number:
**WO 2025/023609 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.07.2023 KR 20230097407**

(71) Applicant: **LG Chem, Ltd.
Seoul 07336 (KR)**

(72) Inventors:
• **JUN, Tae Hwan
Daejeon 34122 (KR)**
• **KIM, Dong Hwan
Daejeon 34122 (KR)**
• **KO, Young Min
Daejeon 34122 (KR)**
• **KIM, Jin Sol
Daejeon 34122 (KR)**
• **OH, Myoung Hwan
Daejeon 34122 (KR)**

(74) Representative: **Hoffmann Eitle
Patent- und Rechtsanwälte PartmbB
Arabellastraße 30
81925 München (DE)**

(54) **CATHODE ACTIVE MATERIAL, CATHODE COMPRISING SAME, AND LITHIUM SECONDARY BATTERY**

(57) The present invention relates to a positive electrode active material, which is a bimodal positive electrode active material including a first Li-rich layered manganese-based oxide in a single particle form; and a second Li-rich layered manganese-based oxide in a secondary particle form, wherein the first Li-rich layered manganese-based oxide and the second Li-rich layered manganese-based oxide contain $Li_2MnO_3$ phase and $LiMO_2$ (where, M is an element containing one or more selected from Ni, Co, and Mn) phase at the same time, the first Li-rich layered manganese-based oxide has a smaller average particle diameter ($D_{50}$) than that of the second Li-rich layered manganese-based oxide, and a weight ratio of the first Li-rich layered manganese-based oxide and the second Li-rich layered manganese-based oxide is 1:1.5 to 8, and the present invention relates to a positive electrode and a lithium secondary battery including the same.

[FIG. 1]

(A)

**(Cont. next page)**

[FIG. 1]

[FIG. 1]

[FIG. 1]

(A)

(B)

[FIG. 2]

(A)

(B)

**Description**

## TECHNICAL FIELD

Cross-reference to Related Applications

This application claims priority from Korean Patent Application No. 10-2023-0097407, filed on July 26, 2023, the disclosure of which is incorporated by reference herein.

Technical Field

The present invention relates to a bimodal positive electrode active material, and a positive electrode and a lithium secondary battery including the same, and more particularly, a bimodal positive electrode active material including a Li-rich layered manganese-based oxide, and a positive electrode and a lithium secondary battery including the same.

## BACKGROUND ART

A lithium secondary battery is made up of four major components including a positive electrode, a negative electrode, a separator, and an electrolyte. Among these, a positive electrode active material included in the positive electrode is a material playing a major role in determining a capacity, output, and lifetime of a battery. Improvement in performance of the positive electrode active material is necessary in order for the lithium secondary battery to have high energy density, output, and lifetime, and thus recently, research for developing a high-performance positive electrode active material has been actively conducted.

A Li-rich layered oxide, which is a type of positive electrode active material, has the characteristic of providing a very large capacity of 250 mAh/g at a high operating voltage (>3.5V vs. Li/Li$^+$) in a mixed phase of $Li_2MnO_3$ phase and $LiMO_2$(M is one or more of Ni, Mn, and Co) phase. Therefore, the Li-rich layered oxide is drawing attention as an inexpensive high-capacity positive electrode active material.

Meanwhile, a conventional Li-rich layered oxide in a secondary particle form, which is prepared by a coprecipitation method, has a low pellet density and has a high porosity upon application to an electrode, and therefore, it has a problem of having a low energy density per volume. In addition, there is a problem in that mechanical stress is not distributed when rolling is performed for preparing an electrode, causing particle fracture, so that large amount of gas is generated when a battery operates.

Consequently, development of the Li-rich layered oxide, which has a high pellet density and a low incidence of particle fracture in rolling, is being required.

## DISCLOSURE OF THE INVENTION

## TECHNICAL PROBLEM

The present invention seeks to improve energy density and stability of a positive electrode active material, and consequently to improve performance of a battery including the same.

In addition, the objective of the present invention is to provide a positive electrode and a lithium secondary battery including the positive electrode active material.

## TECHNICAL SOLUTION

In order to solve the technical problem, the present invention provides a positive electrode active material, a positive electrode, and a lithium secondary battery.

(1) The present invention provides a bimodal positive electrode active material including a first Li-rich layered manganese-based oxide in a single particle form; and a second Li-rich layered manganese-based oxide in a secondary particle form, wherein the first Li-rich layered manganese-based oxide and the second Li-rich layered manganese-based oxide contain $Li_2MnO_3$ phase and $LiMO_2$(where, M is an element containing one or more selected from Ni, Co, and Mn) phase at the same time, the first Li-rich layered manganese-based oxide has a smaller average particle diameter ($D_{50}$) than that of the second Li-rich layered manganese-based oxide, and a weight ratio of the first Li-rich layered manganese-based oxide and the second Li-rich layered manganese-based oxide is 1:1.5 to 8.

(2) The present invention provides the bimodal positive electrode active material of (1) above, wherein the first Li-rich layered manganese-based oxide has a degree of single crystallinity ($\chi$) of 0.4 or greater according to Equation 1

below.

$$\text{[Equation 1]}$$

$$X = \sum_i a_i{}^2$$

In Equation 1 above,

when a single particle is formed of i crystal grains, ai refers to a value ($A_i$/A) of a cross-sectional area ($A_i$) of an i-th crystal grain to a cross-sectional area (A) of the single particle.

(3) The present invention provides the bimodal positive electrode active material of (1) or (2) above, wherein the first Li-rich layered manganese-based oxide has an average particle diameter ($D_{50}$) of 0.5 $\mu$m to 3.5 $\mu$m.

(4) The present invention provides the bimodal positive electrode active material of any one of (1) to (3) above, wherein the second Li-rich layered manganese-based oxide has an average particle diameter ($D_{50}$) of 5.0 $\mu$m to 10.0 $\mu$m.

(5) The present invention provides the bimodal positive electrode active material of any one of (1) to (4) above, wherein the first Li-rich layered manganese-based oxide has a composition represented by Chemical Formula 1 below.

$$\text{[Chemical Formula 1]} \qquad Li_{1+x1}Ni_{a1}Mn_{b1}M^1{}_{c1}O_{y1}$$

In Chemical Formula 1 above,

$M^1$ is one or more selected from Co, Mo, W, V, Zr, Al, and Nb,
$0.1 \leq x1 \leq 0.2$, $0 < a1 \leq 0.5$, $0.5 \leq b1 \leq 0.75$, $0 \leq c1 \leq 0.1$, and $0 \leq y1 \leq 2.0$, and
$x1+a1+b1+c1=1.0$.

(6) The present invention provides the bimodal positive electrode active material of any one of (1) to (5) above, wherein the second Li-rich layered manganese-based oxide has a composition represented by Chemical Formula 2 below.

$$\text{[Chemical Formula 2]} \qquad Li_{1+x2}Ni_{a2}Mn_{b2}M^2{}_{c2}O_{y2}$$

In Chemical Formula 2 above,

$M^2$ is one or more selected from Co, Mo, W, V, Zr, Al, and Nb,
$0.1 \leq x2 \leq 0.2$, $0 < a2 \leq 0.5$, $0.5 \leq b2 \leq 0.75$, $0 \leq c2 \leq 0.1$, and $0 \leq y2 \leq 2.0$, and
$x2+a2+b2+c2=1.0$.

(7) The present invention provides the bimodal positive electrode active material of any one of (1) to (6) above, wherein a pellet density is 2.20 $g/cm^3$ to 2.70 $g/cm^3$.

(8) The present invention provides a positive electrode including the positive electrode active material according to any one of (1) to (7) above.

(9) The present invention provides a lithium secondary battery including the positive electrode according to (8) above.

## ADVANTAGEOUS EFFECTS

A positive electrode active material of the present invention includes a small-particle Li-rich layered manganese-based oxide in a single particle form and a large-particle Li-rich layered manganese-based oxide in a secondary particle form at the same time in a particular weight ratio, and thus has excellent energy density and stability, and consequently, a battery including the positive electrode active material may have improved performance, for example, improved capacity characteristics, energy density, etc., and particle fracture of the positive electrode active material may be prevented during preparation or operation of the battery.

## BRIEF DESCRIPTION OF THE DRAWINGS

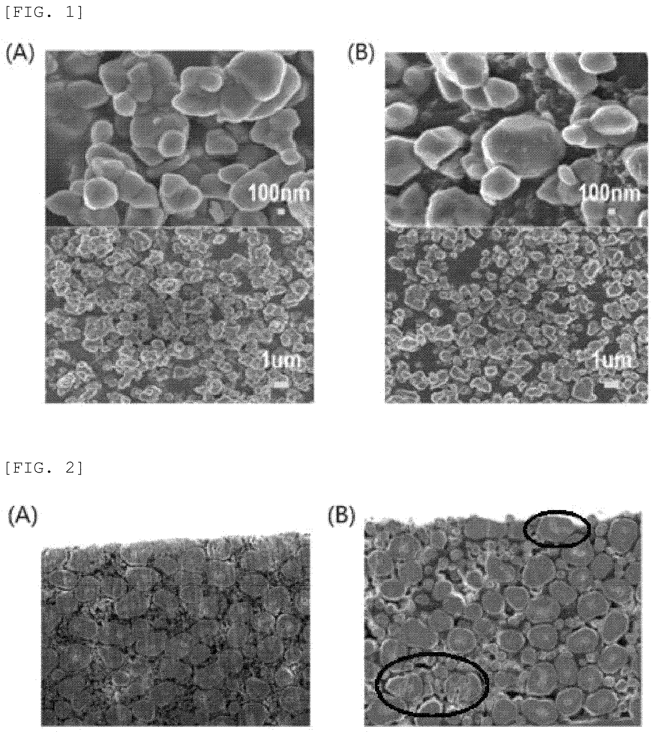

FIG. 1 shows SEM images of Li-rich layered manganese-based oxides prepared according to Preparation Examples 1 and 2. In particular, FIG. 1(A) is a SEM image of a Li-rich layered manganese-based oxide (A1) prepared according to Preparation Example 1, and FIG. 1(B) is a SEM image of a Li-rich layered manganese-based oxide (A2) prepared according to Preparation Example 2.

FIG. 2 shows cross-sectional SEM images of positive electrodes including positive electrode active materials according to Example 1 and Comparative Example 1. In particular, FIG. 2(A) is a cross-sectional SEM image of a positive electrode including a positive electrode active material according to Example 1, and FIG. 2(B) is a cross-sectional SEM image of a positive electrode including a positive electrode active material according to Example 2.

## BEST MODE FOR CARRYING OUT THE INVENTION

Hereinafter, the present invention will be described in more detail in order to aid understanding of the present invention.

It will be understood that terms or words used in the specification and claims of the present invention shall not be interpreted as the meaning defined in commonly used dictionaries, and it will be further understood that the terms or words should be interpreted as having a meaning that is consistent with their meaning in the context of the relevant art and the technical idea of the invention, based on the principle that an inventor may properly define the meaning of the terms or words to best explain the invention.

It will be further understood that the terms 'comprise', 'include', 'have' or the like, when used in this specification, specify the presence of stated features, integers, steps, elements, or a combination thereof, but do not preclude the presence or addition of one or more other features, integers, steps, elements, or a combination thereof.

In this specification, a 'single particle form' is a concept in contrast to a spherical secondary particle form formed by aggregation of tens to hundreds of primary particles, and refers to being formed of ten or less primary particles. In particular, the 'single particle form' may also refer to a single particle form made of one primary particle, or to a secondary particle form in which several primary particles are aggregated.

In this specification, a 'primary particle' refers to a minimum unit of a particle recognized when a positive electrode active material is observed by using a scanning electron microscope (SEM), and may be formed of a plurality of crystal grains, and a 'secondary particle' refers to a secondary structural body formed by aggregation of a plurality of primary particles.

In this specification, a 'single crystal' refers to a crystal in a state where a grain boundary is not included inside the particle.

In this specification, a 'crystal grain' refers to a particle unit that substantially has the same crystal orientation, and may be measured using Electron Backscatter Diffraction (EBSD). In particular, the crystal grain is a minimum particle unit marked in the same color on an IPF map obtained by the EBSD analysis on a cross-section of a positive electrode active material cut through ion milling.

In this specification, an average particle diameter ($D_{50}$) may be defined as a particle diameter corresponding to 50% of cumulative volume in a particle diameter distribution curve of particles. The average particle diameter ($D_{50}$) may be measured by using, for example, a laser diffraction method, and more particularly, a lithium composite transition metal oxide is dispersed in a dispersion medium, then the dispersion medium is introduced into a commercial laser diffraction particle size measurement instrument (e.g., Microtrac MT 3000) and irradiated with ultrasonic waves of about 28 kHz at an output of 60 W, and the average particle diameter ($D_{50}$) corresponding to 50% in a particle diameter distribution in the measurement instrument may then be calculated.

In this specification, a pellet density is a value calculated by Equation 2 below when a pellet is formed by applying force until it becomes a force equivalent to 2000 kgf using an automatic pellet press. In particular, the pellet density is a value obtained according to (1) to (3) below.

(1) By using a Universal Testing Machine (UTM) (Instron, 5966 model), the zero point of thickness is adjusted, using a cylindrical mold, for a circular pellet holder.

(2) A positive electrode active material is placed in the circular pellet holder, and force is applied thereto until it reaches a force equivalent to 2000 kgf to form a pellet, and the thickness of the pellet is measured.

(3) A pellet volume is calculated by Equation 2 below, and a pellet density is calculated by Equation 3 below.

$$\text{Pellet volume (cm}^3\text{)} = \pi \text{ (radius of circular pellet holder)}^2 \text{ x thickness of pellet} \qquad \text{[Equation 2]}$$

$$\text{Pellet density (g/cm}^3\text{)} = \text{Weight of positive electrode active material (g) / pellet volume (cm}^3\text{)]]} \qquad \text{[Equation 3]}$$

The present inventors found out that, when a positive electrode active material includes a small-particle Li-rich layered manganese-based oxide in a single particle form and a large-particle Li-rich layered manganese-based oxide in a secondary particle form at the same time, an electrode density may be improved, and particle fracture may be minimized upon application of the positive electrode active material onto a positive electrode for a secondary battery, and when the positive electrode active material is applied to the secondary battery, capacity characteristics, energy density, etc. of the battery may be improved, and particle fracture of the positive electrode active material may be prevented during preparation or operation of the battery, so that gas generation may be suppressed, and therefore, the present invention has been completed.

**Bimodal Positive Electrode Active Material**

A positive electrode active material according to the present invention is a bimodal positive electrode active material including a first Li-rich layered manganese-based oxide in a single particle form (hereinafter, small-particle Li-rich layered manganese-based oxide); and a second Li-rich layered manganese-based oxide in a secondary particle form (hereinafter, large-particle Li-rich layered manganese-based oxide), wherein the first Li-rich layered manganese-based oxide and the second Li-rich layered manganese-based oxide contain $Li_2MnO_3$ phase and $LiMO_2$(where, M is an element containing one or more selected from Ni, Co, and Mn) phase at the same time, the first Li-rich layered manganese-based oxide has a smaller average particle diameter ($D_{50}$) than that of the second Li-rich layered manganese-based oxide, and a weight ratio of the first Li-rich layered manganese-based oxide and the second Li-rich layered manganese-based oxide is 1:1.5 to 8.

Since the bimodal positive electrode active material includes the small-particle Li-rich layered manganese-based oxide and the large-particle Li-rich layered manganese-based oxide containing $Li_2MnO_3$ phase and $LiMO_2$ (where, M is an element including one or more selected from Ni, Co, and Mn) phase at the same time in a particular weight ratio, and thus the small-particle Li-rich layered manganese-based oxide is filled between the large-particle Li-rich layered manganese-based oxide, the pellet density is high, and the stress applied to the large-particle Li-rich layered manganese-based oxide may be distributed, thereby preventing the particle fracture in rolling for preparing an electrode.

The first Li-rich layered manganese-based oxide and the second Li-rich layered manganese-based oxide include $Li_2MnO_3$ phase and $LiMO_2$ (where, M is an element including one or more selected from Ni, Co, and Mn) phase at the same time, and include a monoclinic structure and a rhombohedral structure.

The small-particle Li-rich layered manganese-based oxide may be prepared by dry-mixing a lithium raw material and transition metal raw materials and then performing a calcination process (solid-phase synthesis). In particular, the lithium raw material and the transition metal raw materials are put into a grinding device to perform dry-mixing and grinding (high-energy ball-mill grinding), then the ground raw material is calcined, and the calcined product is crushed to prepare the small-particle Li-rich layered manganese-based oxide. However, the preparation is not limited thereto.

The large-particle Li-rich layered manganese-based oxide may be obtained in the same method as the conventional one, where a precursor is prepared through coprecipitation and then is mixed with the lithium raw material and the mixture is calcined, but the preparation is not limited thereto.

According to the present invention, the first Li-rich layered manganese-based oxide may have a degree of single crystallinity ($\chi$) of 0.4 or greater according to Equation 1 below.

$$[\text{Equation 1}]$$

$$X = \sum_i a_i^{\,2}$$

In Equation 1 above,

When a single particle is formed of i crystal grains, $a_i$ refers to a value ($A_i/A$) of a cross-sectional area ($A_i$) of an i-th crystal grain to a cross-sectional area (A) of the single particle.

In the present invention, the degree of single crystallinity was evaluated and expressed in parameter represented by Equation 1 above. In the present invention, the degree of single crystallinity refers to a value adjusted according to the number of crystal grains constituting one single particle and the area of each crystal grain, wherein as a particular crystal grain, having the largest area in the one single particle, has a large area closer to the area of the entire single particle, the degree of single crystallinity becomes higher.

That is, as the number of crystal grains constituting the single particle is less, the degree of single crystallinity in the present invention may become higher, and if the number of crystal grains is the same, the degree of single crystallinity becomes higher when a particular crystal grain has a larger area than other crystal grains such that the difference in area between the particular crystal grain and the entire single particle is small, rather than when the areas of crystal grains are similar.

For example, the maximum value of the degree of single crystallinity is 1, which means that one single particle is formed of one crystal grain (single-crystal single particle). Also, when one single particle is formed of N crystal grains, the degree of single crystallinity differs according to the area of each crystal grain, but the minimum value of the degree of single crystallinity possible with N crystal grains is 1/N, and this is the case where all of the N crystal grains have the same area. Even though one single particle is formed of N crystal grains, if a particular crystal grain has a larger area than other crystal grains, the degree of single crystallinity becomes higher than 1/N, and this is because the shape is closer to the single crystal when the particular crystal grain has the largest area, than when the N crystal grains have the same area.

From this perspective, as the area of a crystal grain to be added is smaller, the degree of single crystallinity decreases to a small extent, which implies that since the area of the small-sized crystal grain is smaller than the area of the entire particle, effect on decreasing the degree of single crystallinity is low.

The degree of single crystallinity of the first Li-rich layered manganese-based oxide may be particularly 0.4, 0.45, 0.5, 0.55, 0.6 or greater, 0.65, 0.7, 0.75, 0.8 or less. When the degree of single crystallinity of the first Li-rich layered manganese-based oxide falls within the above ranges, one single particle is formed of 10 or less crystal grains, so that there is an advantage of less particle fracture. Accordingly, since particle fracture caused by a grain boundary is suppressed during an electrode rolling and operation of a battery, gas generation may be suppressed, and since the area of the grain boundary in contact with an electrolyte solution is reduced, side reactions with the electrolyte solution may be reduced, thereby significantly improving the lifetime of a secondary battery.

According to the present invention, the first Li-rich layered manganese-based oxide has an average particle diameter ($D_{50}$) of 0.5 $\mu$m to 3.5 $\mu$m. In particular, the average particle diameter ($D_{50}$) of the first Li-rich layered manganese-based oxide may be 0.5 $\mu$m, 0.7 $\mu$m, 0.9 $\mu$m or greater, 1.1 $\mu$m, 1.5 $\mu$m, 2.0 $\mu$m, 3.5 $\mu$m or less.

According to the present invention, the second Li-rich layered manganese-based oxide may have an average particle diameter ($D_{50}$) of 5.0 $\mu$m to 10.0 $\mu$m. In particular, the average particle diameter ($D_{50}$) of the second Li-rich layered manganese-based oxide may be 5.0 $\mu$m, 5.5 $\mu$m, 6.0 $\mu$m, 6.5 $\mu$m or greater, 7.5 $\mu$m, 8.0 $\mu$m, 9.0 $\mu$m, 10.0 $\mu$m or less.

When the average particle diameter ($D_{50}$) of each of the first lithium transition metal oxide and the second lithium transition metal oxide falls within the above ranges, the second lithium transition metal oxide may be distributed appropriately between the first lithium transition metal oxide, exhibiting an excellent filling rate.

The ratio of the average particle diameter of the first Li-rich layered manganese-based oxide and the average particle diameter of the second Li-rich layered manganese-based oxide may be 1:3 to 5. When the ratio of the average particle diameter of the first Li-rich layered manganese-based oxide and the average particle diameter of the second Li-rich layered manganese-based oxide falls within the above range, there is an advantage that the pellet density is improved as well as the filling rate is excellent.

According to the present invention, the first Li-rich layered manganese-based oxide may have a composition represented by Chemical Formula 1 below.

[Chemical Formula 1] $\quad\quad Li_{1+x1}Ni_{a1}Mn_{b1}M^1_{c1}O_{y1}$

In Chemical Formula 1 above,

$M^1$ is one or more selected from Co, Mo, W, V, Zr, Al, and Nb,
$0.1 \leq x1 \leq 0.2$, $0 < a1 \leq 0.5$, $0.5 \leq b1 \leq 0.75$, $0 \leq c1 \leq 0.1$, and $0 \leq y1 \leq 2.0$, and
$x1+a1+b1+c1=1.0$.

$M^1$ above is a doping element, and in particular, $M^1$ above may be one or more selected from Co, Mo, W, V, Zr, Al, and Nb. $M^1$ above may not be necessarily included, but if included in an appropriate amount, a particle shape of the first Li-rich layered manganese-based oxide may be improved, and stability of crystal structure may be improved.

x1 above may be 0.10, 0.11, 0.12, 0.13, 0.14 or greater, and 0.16, 0.17, 0.18, 0.19, 0.20 or less. When x1 falls within the above range, high-capacity characteristics and high energy density per unit volume may be achieved.

a1 above may be greater than 0, 0.1, 0.2 or greater, and 0.3, 0.4, 0.5 or less. When a1 falls within the above range, the first Li-rich layered manganese-based oxide may exhibit high energy density, thereby achieving high-capacity characteristics.

b1 above may be 0.50, 0.51, 0.52, 0.53, 0.54, 0.55 or greater, and 0.60, 0.61, 0.62, 0.63, 0.64, 0.65, 0.66, 0.67, 0.68, 0.69, 0.70, 0.71, 0.72, 0.73, 0.74, 0.75 or less. When b1 falls within the above range, high-capacity characteristics may be achieved. In addition, high-temperature stability of the first Li-rich layered manganese-based oxide may be improved, and decomposition reaction of an electrolyte solution may be relatively reduced.

c1 above may be 0 or greater, and 0.01, 0.02, 0.03, 0.04, 0.05, 0.06, 0.07, 0.08, 0.09, 0.10 or less. When c1 falls within the above range, the first Li-rich layered manganese-based oxide may have improved stability of crystal structure, and the particle shape may be improved.

Meanwhile, the first Li-rich layered manganese-based oxide may not include cobalt which is expensive, and may improve performance of a lithium secondary battery even without cobalt.

According to the present invention, the second Li-rich layered manganese-based oxide may have a composition represented by Chemical Formula 2 below.

[Chemical Formula 2]     $Li_{1+x2}Ni_{a2}Mn_{b2}M^2_{c2}O_{y2}$

In Chemical Formula 2 above,

$M^2$ is one or more selected from Co, Mo, W, V, Zr, Al, and Nb,
$0.1 \leq x2 \leq 0.2$, $0 < a2 \leq 0.5$, $0.5 \leq b2 \leq 0.75$, $0 \leq c2 \leq 0.1$, and $0 \leq y2 \leq 2.0$, and
$x2+a2+b2+c2=1.0$.

$M^2$ above is a doping element, and in particular, $M^2$ above may be one or more selected from Co, Mo, W, V, Zr, Al, and Nb. $M^2$ above may not be necessarily included, but if included in an appropriate amount, the particle shape of the second Li-rich layered manganese-based oxide may be improved, and stability of crystal structure may be improved.
$x2$ above may be 0.10, 0.11, 0.12, 0.13, 0.14 or greater, and 0.16, 0.17, 0.18, 0.19, 0.20 or less. When $x2$ falls within the above range, high-capacity characteristics and high energy density per unit volume may be achieved.
$a2$ above may be greater than 0, 0.1, 0.2 or greater, and 0.3, 0.4, 0.5 or less. When $a2$ falls within the above range, the second Li-rich layered manganese-based oxide may exhibit high energy density, thereby achieving high-capacity characteristics.
$b2$ above may be 0.50, 0.51, 0.52, 0.53, 0.54, 0.55 or greater, and 0.60, 0.61, 0.62, 0.63, 0.64, 0.65, 0.66, 0.67, 0.68, 0.69, 0.70, 0.71, 0.72, 0.73, 0.74, 0.75 or less. When $B2$ falls within the above range, high-capacity characteristics may be achieved. In addition, high-temperature stability of the second Li-rich layered manganese-based oxide may be improved, and decomposition reaction of an electrolyte solution may be relatively reduced.
$c2$ above may be 0 or greater, and 0.01, 0.02, 0.03, 0.04, 0.05, 0.06, 0.07, 0.08, 0.09, 0.10 or less. When $C2$ falls within the above range, the second Li-rich layered manganese-based oxide may have improved stability of crystal structure, and the particle shape may be improved.
Meanwhile, the second Li-rich layered manganese-based oxide may not include cobalt which is expensive, and may improve performance of a lithium secondary battery even without cobalt.
According to the present invention, the weight ratio of the first Li-rich layered manganese-based oxide and the second Li-rich layered manganese-based oxide may be 1:1.5 to 8. In particular, the weight ratio of the first Li-rich layered manganese-based oxide and the second Li-rich layered manganese-based oxide may be 1:1.5 to 8, 1:1.5 to 7, 1:1.5 to 6, 1:1.5 to 5, 1:1.5 to 4, 1:1.5 to 3, or 1:1.5 to 2. When the weight ratio of the first Li-rich layered manganese-based oxide and the second Li-rich layered manganese-based oxide falls within the above ranges, the filling density of particles may be increased, and consequently, a battery capacity, energy density, etc. may be increased upon application to the battery.
According to the present invention, the bimodal positive electrode active material may have a pellet density of 2.20 g/cm³ to 2.70 g/cm³. In particular, the pellet density of the bimodal positive electrode active material may be 2.20 g/cm³, 2.40 g/cm³, 2.50 g/cm³, 2.60 g/cm³ or greater, 2.65 g/cm³, 2.70 g/cm³ or less. When the pellet density of the bimodal positive electrode active material falls within the above range, capacity characteristics, energy density, etc. may be improved, and particle fracture of the positive electrode active material may be prevented during preparation or operation of a battery.

**Positive Electrode**

The present invention provides a positive electrode including the positive electrode active material. That is, a positive electrode including the bimodal positive electrode active material is provided.
The positive electrode may include a positive electrode current collector, and a positive electrode active material layer formed on the positive electrode current collector, and the positive electrode active material layer may include the positive electrode active material.
The positive electrode current collector may include a highly conductive metal, and the metal is not particularly limited as long as it is non-reactive in a voltage range of a battery while the positive electrode active material layer is easily adhered thereto. For the positive electrode current collector, for example, stainless steel, aluminum, nickel, titanium, calcined carbon, aluminum or stainless steel that is surface-treated with carbon, nickel, titanium, silver, etc. or the like may be used. In addition, the positive electrode current collector may generally have a thickness of 3 μm to 500 μm, and microscopic irregularities may be formed on a surface of the current collector to improve adhesion of the positive electrode active material. For example, the positive electrode current collector may be used in various forms including a film, a sheet, a foil, a net, a porous body, a foam body, a non-woven fabric body, etc.
The positive electrode active material layer may include, selectively as needed, a conductive material and a binder, together with the positive electrode active material. At this time, the positive electrode active material may be included in an amount of 80 wt% to 99 wt%, and more particularly, 85 wt% to 98.5 wt% on the basis of the total weight of the positive electrode active material layer, and in this range, excellent capacity characteristics may be exhibited.

The conductive material may be used to provide conductivity to an electrode, and any material may be used in the battery, without particular limitation, as long as it does not cause chemical changes and conducts electrons. Specific examples may be graphite such as natural graphite or artificial graphite; a carbon-based material including carbon black, acetylene black, ketjen black, channel black, furnace black, lamp black, thermal black, a carbon fiber, etc.; a powder or fiber of metal including copper, nickel, aluminum, silver, etc.; a conductive tube including carbon nanotube, etc.; a conductive whisker including zinc oxide, potassium titanate, etc.; a conductive metal oxide including titanium oxide, etc.; or a conductive polymer including a polyphenylene derivative, etc., and any one alone or a mixture of two or more thereof may be used. The conductive material may be included in an amount of 0.1 wt% to 15 wt% on the basis of the total weight of the positive electrode active material layer.

The binder serves to improve binding between the positive electrode active material particles and adhesion between the positive electrode active material and the current collector. Specific examples may be polyvinylidene fluoride (PVDF), polyvinylidene fluoride-hexafluoropropylene copolymer (PVDF-co-HFP), polyvinylalcohol, polyacrylonitrile, polymethymethaxrylate, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated-EPDM, a styrene-butadiene rubber (SBR), a fluorine rubber, poly acrylic acid, and a polymer in which hydrogen thereof is substituted with Li, Na, or Ca, or various copolymers thereof, and any one alone or a mixture of two or more thereof may be used. The binder may be included in an amount of 0.1 wt% to 15 wt% on the basis of the total weight of the positive electrode active material layer.

The positive electrode may be prepared according to a general preparation method for a positive electrode, except that the above-described positive electrode active material is used. In particular, the positive electrode active material, and selectively as needed, a binder, a conductive material, and a dispersant are dissolved or dispersed in a solvent to prepare a composition for forming a positive electrode active material layer, then the composition is applied onto a positive electrode current collector and then dried and pressed to prepare the positive electrode, or casting of the composition for forming the positive electrode active material layer is performed onto a separate support, and a film separated from the support is then laminated on the positive electrode current collector to thereby prepare the positive electrode.

The solvent may be a solvent generally used in the art, including dimethyl sulfoxide (DMSO), isopropyl alcohol, N-methylpyrrolidone (NMP), dimethylformamide (DMF), acetone, water, or the like, and any one alone or a mixture of two or more thereof may be used. The amount of the solvent used is sufficient if it dissolves or disperses the positive electrode active material, the conductive material, the binder, and the dispersant therein in consideration of the thickness of the slurry to be applied and the manufacturing yield, and provides a viscosity that allows excellent thickness uniformity upon application for preparation of the positive electrode thereafter.

### Lithium Secondary Battery

The present invention provides a lithium secondary battery including the positive electrode.

The lithium secondary battery may include the positive electrode; a negative electrode; a separator introduced between the positive electrode and the negative electrode, and an electrolyte. In addition, the lithium secondary battery may selectively further include a battery case that accommodates an electrode assembly of the positive electrode, the negative electrode, and the separator, and a sealing member that seals the battery case.

The negative electrode may include a negative electrode current collector, and a negative electrode active material layer positioned on the negative electrode current collector.

The negative electrode current collector is not particularly limited as long as it does not cause chemical changes to a battery and has high conductivity, and for example, copper, stainless steel, aluminum, nickel, titanium, calcined carbon, copper or stainless steel that is surface-treated with carbon, nickel, titanium, silver, etc., an aluminum-cadmium alloy, etc. may be used. Also, the negative electrode current collector may generally have a thickness of 3 $\mu$m to 500 $\mu$m, and like the positive electrode current collector, microscopic irregularities may be formed on a surface of the current collector to strengthen binding force of the negative electrode active material. For example, the negative electrode current collector may be used in various forms including a film, a sheet, a foil, a net, a porous body, a foam body, a non-woven fiber body, etc.

The negative electrode active material layer may include, selectively as needed, a binder and a conductive material, together with the negative electrode active material.

A compound capable of reversible intercalation and deintercalation of lithium may be used as the negative electrode active material. Specific examples may be a carbon-based material including artificial graphite, natural graphite, graphitized carbon fiber, amorphous carbon, etc.; a metal-based compound capable of alloying with lithium including Si, Al, Sn, Pb, Zn, Bi, In, Mg, Ga, Cd, Si alloy, Sn alloy, or Al alloy; a metal oxide capable of doping or dedoping lithium such as $SiO_\beta(0<\beta<2)$, $SnO_2$, vanadium oxide, and lithium vanadium oxide; or a composite containing the metal-based compound and the carbon-based material such as a Si-C composite or a Sn-C composite, and any one or a mixture of two or more thereof may be used. In addition, as the negative electrode active material, a metal lithium thin film may also be used. In addition, for the carbon material, low-crystalline carbon, high-crystalline carbon, and the like may be all used. Representative examples of the low-crystalline carbon include soft carbon and hard carbon, and representative examples of the high-crystalline carbon include non-shaped, plate-shaped, scaly, spherical, or fibrous natural graphite or artificial graphite, Kish graphite, pyrolytic carbon, mesophase pitch based carbonfiber, meso-carbon microbeads, mesophase pitches, high-temperature calcined carbon such as petroleum or coal tar pitch derived cokes, and the like. The negative electrode active material may be included in an amount of 80 wt% to 99 wt% on the basis of the total weight of the negative electrode active material layer.

The binder of the negative electrode active material layer is a component that assists binding between the conductive material, the active material, and the current collector, and is generally included in an amount of 0.1 wt% to 10 wt% on the basis of the total weight of the negative electrode active material layer. Examples of this binder may include polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated-EPDM, a styrene-butadiene rubber, a nitrile-butadiene rubber, a fluorine rubber, various copolymers thereof, etc.

The conductive material of the negative electrode active material layer is a component that further improves conductivity of the negative electrode active material, and may be included in an amount of 10 wt% or less, and preferably 5 wt% or less on the basis of the total weight of the negative electrode active material layer. The conductive material is not particularly limited as long as it does not cause chemical changes to a battery and has conductivity, and for example, graphite such as natural graphite or artificial graphite; carbon black including acetylene black, ketjen black, channel black, furnace black, lamp black, thermal black, etc.; a conductive fiber including a carbon fiber, metal fiber, or the like; fluorocarbon; metal powder including aluminum power, nickel powder, etc.; a conductive whisker including zinc oxide, potassium titanate, etc.; a conductive metal oxide including titanium oxide, etc.; a conductive material including a polyphenylene derivative, etc. may be used.

The negative electrode active material, and selectively as needed, the binder and the conductive material are dissolved or dispersed in a solvent to prepare a composition for forming a negative electrode active material layer, then the composition is applied onto the negative electrode current collector and dried to prepare the negative electrode, or casting of the composition for forming the negative electrode active material layer is performed onto a separate support, and a film separated from the support is then laminated on the negative electrode current collector to thereby prepare the negative electrode.

The separator separates the negative electrode and the positive electrode and provides a movement path of lithium ions, any separators generally used for a lithium secondary battery may be used without particular limitation, and particularly, a separator having low resistance to ion movement in an electrolyte and having excellent electrolyte solution moisture-absorbing ability is preferred. In particular, a porous polymer film, for example, a porous polymer film prepared with a polyolefin-based polymer such as an ethylene homopolymer, a propylene homopolymer, an ethylene/butene copolymer, an ethylene/hexene copolymer, and an ethylene/methacrylate copolymer, or a laminated structure having two or more layers thereof, may be used. In addition, a general porous non-woven fabric, for example, a non-woven fabric made of glass fiber with high melting point, polyethylene terephthalate fiber, etc. may also be used. Furthermore, a coated separator including a ceramic component, or a polymer material may also be used in order to secure heat resistance or mechanical strength, and may be used selectively in a single-layer or multi-layer structure.

The electrolyte may include an organic liquid electrolyte, an inorganic liquid electrolyte, a solid polymer electrolyte, a gel-type polymer electrolyte, a solid inorganic electrolyte, a molten-type inorganic electrolyte, etc., which may be used in preparation of a lithium secondary battery, and the type is not limited thereto. Specific examples of the electrolyte may include an organic solvent and a lithium salt.

Any organic solvent may be used as the organic solvent, without particular limitation, as long as it may serve as a medium through which ions involved in an electrochemical reaction of the battery may move. In particular, as the organic solvent, an ester-based solvent including methyl acetate, ethyl acetate, γ-butyrolactone, ε-caprolactone, etc.; an ether-based solvent including dibutyl ether, tetrahydrofuran, or the like; a ketone-based solvent including cyclohexanone, etc.; an aromatic hydrocarbon-based solvent including benzene, fluorobenzene, etc.; a carbonate-based solvent including dimethylcarbonate (DMC), diethylcarbonate (DEC), methylethylcarbonate (MEC), ethylmethylcarbonate (EMC), ethylenecarbonate (EC), propylene carbonate (PC), etc.; an alcohol-based solvent including ethylalcohol, isopropyl alcohol, etc.; nitriles including R-CN (where, R is a linear, branched, or cyclic C2 to C20 hydrocarbon group, and may include a double-bond aromatic ring or an ether bond), etc.; amides including dimethylformamide, etc.; dioxolanes including 1,3-dioxolane, etc.; or sulfolanes may be used. Among these, a carbonate-based solvent is preferred, and a mixture of a cyclic carbonate (for example, ethylene carbonate, propylene carbonate, or the like) having high ionic conductivity and high dielectric constant capable of increasing charging and discharging performance of a battery, and a low-viscosity linear carbonate-based compound (for example, ethylmethyl carbonate, dimethyl carbonate, diethyl carbonate, or the like) is more preferred.

Any compound capable of providing lithium ions that are used in a lithium secondary battery may be used for the lithium salt without particular limitation. In particular, negative ions of the lithium salt may be at least one selected from the group consisting of $F^-$, $Cl^-$, $Br^-$, $I^-$, $NO_3^-$, $N(CN)_2^-$, $BF_4^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$, and $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, $LiCl$, $LiI$, $LiB(C_2O_4)_2$ or the like may be used as the lithium salt. The lithium salt may be used in a concentration range of 0.1 M to 2.0 M. When the concentration of lithium salt falls within the above range, the electrolyte may have appropriate conductivity and viscosity, and therefore, excellent performance of the electrolyte may be exhibited, and lithium ions may move effectively.

In addition to the electrolyte components, in order to improve lifetime characteristics of the battery, suppress the reduction in battery capacity, and improve discharge capacity of the battery, at least one additive, for example, a halo-alkylene carbonate-based compound such as difluoro ethylenecarbonate, pyridine, triethylphosphite, triethanolamine, cyclic ether, ethylene diamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, aluminum trichloride, or the like, may be further included in the electrolyte. At this time, the additive may be included in an amount of 0.1 wt% to 5 wt% on the basis of the total weight of the electrolyte.

Since the lithium secondary battery, including the positive electrode active material according to the present invention, stably exhibits excellent capacity characteristics, output characteristics, and lifetime characteristics, it is useful in the field of portable devices such as a mobile phone, a laptop computer, and a digital camera, in the field of electric vehicles such as a hybrid electric vehicle (HEV) and an electric vehicle (EV), and the like.

An outer shape of the lithium secondary battery of the present invention is not particularly limited, but may include a cylindrical type using a can, a prismatic type, a pouch type, a coin type, or the like.

The lithium secondary battery according to the present invention may not only be used in a battery cell that is used as a power source of a small device, but may also be preferably used as a unit battery in a medium and large-sized battery module including a plurality of battery cells.

Accordingly, a battery module including the lithium secondary battery as a unit cell, and a battery pack including the battery module are provided.

The battery module or battery pack may be used as a power source for any one or more medium and large-sized devices among a power tool; an electric vehicle including an electric vehicle (EV), a hybrid electric vehicle, and a plug-in hybrid electric vehicle (PHEV); or a system for power storage.

## MODE FOR CARRYING OUT THE INVENTION

Hereinafter, examples of the present invention will be described in detail so that those skilled in the art may easily carry out the present invention. However, the present invention may be implemented in several different forms, and is not limited to the examples to be described herein.

### Preparation Example

### Preparation Example 1

$Li_2CO_3$, $NiCO_3$, and $MnO_2$ were dry-mixed such that a molar ratio of lithium, nickel, and manganese became 1.143:0.286:0.571, the mixture was ground for 30 minutes under 1600 rpm using a High Energy Ball milling instrument (a product of Zoz), and then calcined at 1000 °C under air atmosphere to prepare a calcined product. The calcined product was ground using a Jet mill instrument under a condition of 3.5 bar to prepare a Li-rich layered manganese-based oxide (A1) in a single particle form having a composition represented by $Li_{1.143}Ni_{0.286}Mn_{0.571}O_2$, and having an average particle diameter ($D_{50}$) of 1 $\mu$m. A SEM image of the Li-rich layered manganese-based oxide (A1), measured by using a SEM (a product of JEOL, JSM7610F), was shown in FIG. 1(A).

### Preparation Example 2

A Li-rich layered manganese-based oxide (A2) in a single particle form having a composition represented by $Li_{1.16}Ni_{0.24}Mn_{0.60}O_2$ and having an average particle diameter ($D_{50}$) of 1 $\mu$m was prepared in the same manner as that of Preparation Example 1, except that $Li_2CO_3$, $NiCO_3$, and $MnO_2$ were dry-mixed such that a molar ratio of lithium, nickel, and manganese became 1.16:0.24:0.60. A SEM image of the Li-rich layered manganese-based oxide (A2), measured by using a SEM (a product of JEOL, JSM7610F), was shown in FIG. 1(B).

### Examples

#### Example 1

A Li-rich layered manganese-based oxide (B1) in a secondary particle form, having a composition represented by $Li_{1.14}Ni_{0.28}Mn_{0.58}O_2$ and having an average particle diameter ($D_{50}$) of 6.97 μm, was prepared.
The Li-rich layered manganese-based oxide (A1) in a single particle form, prepared according to Preparation Example 1, and the Li-rich layered manganese-based oxide (B1) in a secondary particle form were mixed in a weight ratio of 1:4 to prepare a bimodal positive electrode active material.

#### Example 2

A bimodal positive electrode active material was prepared in the same manner as that of Example 1, except that the Li-rich layered manganese-based oxide (A2) in a single particle form, prepared according to Preparation Example 2, was used instead of the Li-rich layered manganese-based oxide (A1) in a single particle form prepared according to Preparation Example 1.

#### Example 3

The Li-rich layered manganese-based oxide (A1) in a single particle form, prepared according to Preparation Example 1, and the Li-rich layered manganese-based oxide (B1) in a secondary particle form were mixed in a weight ratio of 35:65 (=1:1.86) to prepare a bimodal positive electrode active material.

#### Comparative Example 1

The Li-rich layered manganese-based oxide (B1) in a secondary particle form, used in Example 1 above, was used as a positive electrode active material in Comparative Example 1.

#### Comparative Example 2

The Li-rich layered manganese-based oxide (A1) in a single particle form, prepared according to Preparation Example 1 above, was used as a positive electrode active material in Comparative Example 2.

#### Comparative Example 3

The Li-rich layered manganese-based oxide (A1) in a single particle form, prepared according to Preparation Example 1, and the Li-rich layered manganese-based oxide (B1) in a secondary particle form were mixed in a weight ratio of 1:1 to prepare a bimodal positive electrode active material.

#### Comparative Example 4

The Li-rich layered manganese-based oxide (A1) in a single particle form, prepared according to Preparation Example 1, and the Li-rich layered manganese-based oxide (B1) in a secondary particle form were mixed in a weight ratio of 9:1 (=1:0.11) to prepare a bimodal positive electrode active material.

#### Comparative Example 5

The Li-rich layered manganese-based oxide (A1) in a single particle form, prepared according to Preparation Example 1, and the Li-rich layered manganese-based oxide (B1) in a secondary particle form were mixed in a weight ratio of 1:9 to prepare a bimodal positive electrode active material.

### Experimental Example

#### Experimental Example 1: Evaluation on Pellet Density

By using an Auto Pellet Press (Carver, 3887.4), the zero point of thickness was adjusted using a cylindrical mold for a circular pellet holder having a diameter of 13 mm. Next, 3 g of each of the positive electrode active materials prepared according to Examples 1 to 3 and Comparative Examples 1 to 5 were put into the circular pellet holder, and force was applied thereto until it reaches a force equivalent to 2000 kgf to form a pellet, and the thickness of the pellet was measured. Thereafter, the pellet volume was calculated by Equation 2 below, the pellet density was calculated by Equation 3 below, and the values were listed in Table 1 below.

Pellet volume ($cm^3$) = π (radius of circular pellet holder)$^2$ x thickness of pellet          [Equation 2]

Pellet density ($g/cm^3$) = Weight of positive electrode active material (g) / pellet volume ($cm^3$)          [Equation 3]

**Experimental Example 2: Evaluation on Particle Fracture after Rolling**

The positive electrode active material of each of the examples and comparative examples, Super P as a conductive material, polyvinylidene fluoride (PVDF) as a binder were mixed in an N-methylpyrrolidone (NMP) solvent in a weight ratio of 92:4:4 to prepare a positive electrode slurry. 5 g of the prepared positive electrode slurry was applied to one side of an aluminum current collector, then dried at 130 °C, and then pressed to prepare a positive electrode. Meanwhile, in case of the positive electrodes including the positive electrode active materials according to Examples 1 to 3 and Comparative Example 2, rolling was performed so that an electrode porosity became 22%, and in case of the positive electrodes including the positive electrode active materials according to Comparative Examples 1, 3, and 4, rolling was performed so that the electrode porosity became 30% because no matter how much rolling was performed, the height did not decrease beyond a certain level.

The pressed positive electrode was cut in a method of Focused Ion Beam (FIB), and a cut surface of the positive electrode active material layer was obtained. A SEM image of the cut surface of the positive electrode active material layer was measured using a SEM (JEOL, JSM7610F), and the results were shown in FIG. 2. FIG. 2(A) is a SEM image of a cross-section of the positive electrode including the positive electrode active material according to Example 1, and FIG. 2(B) is a SEM image of a cross-section of the positive electrode including the positive electrode active material according to Example 2.

**Experimental Example 3: Evaluation on Electrode Porosity**

The positive electrode active material of each of the examples and comparative examples, Super P as a conductive material, polyvinylidene fluoride (PVDF) as a binder were mixed in an N-methylpyrrolidone (NMP) solvent in a weight ratio of 92:4:4 to prepare a positive electrode slurry. 5 g of the prepared positive electrode slurry was applied to one side of an aluminum current collector, and then dried at 130 °C to prepare a positive electrode. Rolling was performed on the positive electrode using a rolling mill (a product of welcose), then the height of the pressed positive electrode was measured to calculate the volume, and the amount of the positive electrode active material was reflected to convert an empty space into the porosity. In particular, the porosity (%) was calculated by Equation 4 below, and the values were listed in Table 1 below.

Height after rolling (mm) = [{(Weight of positive electrode active material (mg)- weight of aluminum current collector (mg)) / (Area of positive electrode ($cm^2$) × (1-porosity (%)) ×true density ($g/cm^3$))} +0.02] ×1000          [Equation 4]

**Experimental Example 4: Evaluation on Degree of Single Crystallinity**

The first Li-rich layered manganese-based oxide (A1), a carbon black conductive material, and a PVDF binder were mixed in an NMP solvent in a weight ratio of 95:2:3 to prepare a positive electrode slurry. The positive electrode slurry was applied to one side of an aluminum current collector, and dried and then pressed to prepare a positive electrode. The prepared positive electrode was cut in a FIB method to obtain a cross section of the positive electrode, SEM and EBSD images of the same portion were measured to obtain the shape and area of a particle (obtained from the SEM image) and a cross-section of a crystal grain (obtained from the EBSD image) in the map, then a clustering algorithm was applied to distinguish the crystal grains in the particle, and the degree of single crystallinity of the positive electrode active material was evaluated by Equation 1 of the present invention.

[Equation 1]

$$X = \sum_i a_i^2$$

In Equation 1 above,

When a single particle is formed of i crystal grains, $a_i$ refers to a value $(A_i/A)$ of a cross-sectional area $(A_i)$ of an i-th crystal grain to a cross-sectional area $(A)$ of the single particle.

As a result of the evaluation, the first Li-rich layered manganese-based oxide (A1) has a degree of single crystallinity $(\chi)$ of 0.64 according to Equation 1 below.

**Experimental Example 5: Evaluation on Battery Characteristics**

The positive electrode active material of each of the examples and comparative examples, Super P as a conductive material, polyvinylidene fluoride (PVDF) as a binder were mixed in an N-methylpyrrolidone (NMP) solvent in a weight ratio of 92:4:4 to prepare a positive electrode slurry. The prepared positive electrode slurry was applied to one side of an aluminum current collector, then dried at 130 °C, and then pressed to prepare a positive electrode. Meanwhile, in case of the positive electrodes including the positive electrode active materials according to Examples 1 to 3 and Comparative Example 2, rolling was performed so that an electrode porosity became 22%, and in case of the positive electrodes including the positive electrode active materials according to Comparative Examples 1, 3, and 4, rolling was performed so that the electrode porosity became 30% because no matter how much rolling was performed, the height does not decrease beyond a certain level.

A lithium metal electrode was used as a negative electrode, and a porous polyethylene separator was introduced between the positive electrode and the negative electrode to prepare an electrode assembly. The electrode assembly was positioned inside a battery case, and an electrolyte solution, in which 1 M of $LiPF_6$ was dissolved in an organic solvent of ethylene carbonate (EC): ethylmethyl carbonate (EMC): diethyl carbonate (DEC) being mixed in a volume ratio of 3:4:3, was injected to prepare a coin half-cell.

The coin half-cell including the positive electrode active material of each of the examples and comparative examples was charged at 45 °C and in a mode of CC (0.1 C)-CV (cut-off current: 0.05 C) to 4.65 V, then discharged with 0.1 C to 2.0 V, to perform a formation. Thereafter, the coin half-cell was charged at 25 °C in a mode of CC (0.1 C)-CV (cut-off current: 0.05 C) to 4.25 V, then discharged with 0.1 C to 2.5 V to measure an initial discharge capacity, and the results were listed in Table 1 below.

Thereafter, a cycle of charging and discharging was repeated 30 times in total, where 1 cycle refers to a cycle of charging at 25 °C in a mode of CC (0.33 C)-CV (cut-off current:0.05 C) to 4.25 V and then discharging with 0.33 C to 2.5 V, and after a discharge capacity at 30 cycles was measured, a capacity retention rate was calculated in percentage of the discharge capacity at 30 cycles to the initial discharge capacity, and the values were listed in Table 1 below.

[Table 1]

| Classificati on | Pellet density (g/cm$^3$) | Electrode porosity (%) | Discharge capacity (mAh/g ) | Capacity retention rate (%) |
|---|---|---|---|---|
| Example 1 | 2.629 | 22 | 196.9 | 97.8 |
| Example 2 | 2.601 | 22 | 198.7 | 97.2 |
| Example 3 | 2.600 | 22 | 193.3 | 97.2 |
| Comparative Example 1 | 2.230 | 30 | 198.1 | 98.1 |
| Comparative Example 2 | 2.400 | 22 | 180.9 | 96.2 |
| Comparative Example 3 | 2.594 | 30 | 184.3 | 97.0 |
| Comparative Example 4 | 2.430 | 30 | 182.0 | 96.0 |
| Comparative Example 5 | 2.480 | 22 | 197.2 | 93.4 |

Referring to Table 1 above, it can be seen that, since the bimodal positive electrode active materials of Examples 1 to 3 according to the present invention have high energy density, the pellet density and the electrode porosity were significantly high, and the discharge capacity and the capacity retention rate were in the same level, compared to those of the positive electrode active material of Comparative Example 1. Also, it can be seen that the bimodal positive electrode active materials of Examples 1 to 3 according to the present invention have a significantly high pellet density, and significantly excellent discharge capacity and capacity retention rate, compared to those of the positive electrode active material of Comparative Example 2.

In addition, it can be seen that the bimodal positive electrode active materials of Examples 1 to 3 according to the present invention have a significantly high pellet density, and a significantly excellent discharge capacity, compared to those of the positive electrode active materials of Comparative Example 3 and Comparative Example 4. Furthermore, it can be seen that the bimodal positive electrode active materials of Examples 1 to 3 according to the present invention have a significantly high pellet density, and a significantly excellent capacity retention rate, compared to those of the positive electrode active material of Comparative Example 5.

As a result, it can be seen that the positive electrode active material of the present invention includes a small-particle Li-rich layered manganese-based oxide in a single particle form and a large-particle Li-rich layered manganese-based oxide in a secondary particle form at the same time in a particular weight ratio, and thus has excellent energy density and stability, and consequently, a battery including the same may have improved performance, for example, improved capacity characteristics, energy density, etc., and particle fracture of positive electrode active material may be prevented during preparation or operation of the battery.

**Claims**

1. A bimodal positive electrode active material comprising:

   a first Li-rich layered manganese-based oxide in a single particle form; and
   a second Li-rich layered manganese-based oxide in a secondary particle form,
   wherein the first Li-rich layered manganese-based oxide and the second Li-rich layered manganese-based oxide include $Li_2MnO_3$ phase and $LiMO_2$ (where, M is an element containing one or more selected from Ni, Co, and Mn) phase at the same time,
   the first Li-rich layered manganese-based oxide has a smaller average particle diameter ($D_{50}$) than that of the second Li-rich layered manganese-based oxide, and
   a weight ratio of the first Li-rich layered manganese-based oxide and the second Li-rich layered manganese-based oxide is 1:1.5 to 8.

2. The bimodal positive electrode active material of claim 1, wherein the first Li-rich layered manganese-based oxide has a degree of single crystallinity ($\chi$) of 0.4 or greater according to Equation 1 below:

$$\text{[Equation 1]}$$

$$X = \sum_i {a_i}^2$$

   where, in Equation 1 above,
   when a single particle is formed of i crystal grains, $a_i$ refers to a value ($A_i/A$) of a cross-sectional area ($A_i$) of an i-th crystal grain to a cross-sectional area (A) of the single particle.

3. The bimodal positive electrode active material of claim 1, wherein the first Li-rich layered manganese-based oxide has an average particle diameter ($D_{50}$) of 0.5 $\mu$m to 3.5 $\mu$m.

4. The bimodal positive electrode active material of claim 1, wherein the second Li-rich layered manganese-based oxide has an average particle diameter ($D_{50}$) of 5.0 $\mu$m to 10.0 $\mu$m.

5. The bimodal positive electrode active material of claim 1, wherein the first Li-rich layered manganese-based oxide has a composition represented by Chemical Formula 1 below:

   [Chemical Formula 1]          $Li_{1+x1}Ni_{a1}Mn_{b1}M^1_{c1}O_{y1}$

   where, in Chemical Formula 1 above,
   $M^1$ is one or more selected from Co, Mo, W, V, Zr, Al, and Nb,
   $0.1 \leq x1 \leq 0.2$, $0 < a1 \leq 0.5$, $0.5 \leq b1 \leq 0.75$, $0 \leq c1 \leq 0.1$, and $0 \leq y1 \leq 2.0$, and
   $x1 + a1 + b1 + c1 = 1.0$.

6. The bimodal positive electrode active material of claim 1, wherein the second Li-rich layered manganese-based oxide has a composition represented by Chemical Formula 2 below:

[Chemical Formula 2]    $Li_{1+x2}Ni_{a2}Mn_{b2}M^2_{c2}O_{y2}$

where, in Chemical Formula 2 above,
$M^2$ is one or more selected from Co, Mo, W, V, Zr, Al, and Nb,
$0.1 \leq x2 \leq 0.2$, $0 < a2 \leq 0.5$, $0.5 \leq b2 \leq 0.75$, $0 \leq c2 \leq 0.1$, and $0 \leq y2 \leq 2.0$, and
$x2+a2+b2+c2=1.0$.

7. The bimodal positive electrode active material of claim 1, wherein a pellet density is $2.20$ g/cm$^3$ to $2.70$ g/cm$^3$.

8. A positive electrode comprising the bimodal positive electrode active material according to any one of claim 1 to claim 7.

9. A lithium secondary battery comprising the positive electrode according to claim 8.

[FIG. 1]

[FIG. 2]

## INTERNATIONAL SEARCH REPORT

| International application No. |
| --- |
| **PCT/KR2024/010272** |

**A.     CLASSIFICATION OF SUBJECT MATTER**

**H01M 4/505**(2010.01)i; **H01M 4/525**(2010.01)i; **H01M 10/052**(2010.01)i; **H01M 4/02**(2006.01)i

According to International Patent Classification (IPC) or to both national classification and IPC

**B.     FIELDS SEARCHED**

Minimum documentation searched (classification system followed by classification symbols)

H01M 4/505(2010.01); H01M 10/052(2010.01); H01M 4/131(2010.01); H01M 4/485(2010.01); H01M 4/525(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 단입자(single particle), 층상구조(layered structure), 바이모달(bimodal), 망간 (manganese, Mn), 리튬과잉(lithium-rich), 양극활물질(cathode active material), 이차전지(secondary battery)

**C.     DOCUMENTS CONSIDERED TO BE RELEVANT**

| Category* | Citation of document, with indication, where appropriate, of the relevant passages | Relevant to claim No. |
| --- | --- | --- |
| Y | KR 10-2020-0070649 A (LG CHEM, LTD.) 18 June 2020 (2020-06-18)<br>See claims 1-16. | 1-9 |
| Y | KR 10-2467486 B1 (TOP MATERIAL CO., LTD.) 17 November 2022 (2022-11-17)<br>See claim 1, and paragraph [0006]. | 1-9 |
| A | KR 10-2023-0038123 A (LG ENERGY SOLUTION, LTD.) 17 March 2023 (2023-03-17)<br>See claims 1, 3, 9, 14 and 15. | 1-9 |
| A | KR 10-2019-0139033 A (LG CHEM, LTD.) 17 December 2019 (2019-12-17)<br>See claims 1, 2 and 11. | 1-9 |
| A | KR 10-2019-0092825 A (LG CHEM, LTD.) 08 August 2019 (2019-08-08)<br>See claims 1, 5, 8 and 9. | 1-9 |

☐ Further documents are listed in the continuation of Box C.     ☑ See patent family annex.

| | | |
| --- | --- | --- |
| * | Special categories of cited documents: | "T"  later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X"  document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&"  document member of the same patent family |
| "P" | document published prior to the international filing date but later than the priority date claimed | |

| Date of the actual completion of the international search | Date of mailing of the international search report |
| --- | --- |
| **25 October 2024** | **27 October 2024** |

| Name and mailing address of the ISA/KR | Authorized officer |
| --- | --- |
| **Korean Intellectual Property Office**<br>**Government Complex-Daejeon Building 4, 189 Cheongsa-**<br>**ro, Seo-gu, Daejeon 35208** | |
| Facsimile No. **+82-42-481-8578** | Telephone No. |

Form PCT/ISA/210 (second sheet) (July 2022)

EP 4 734 180 A1

## INTERNATIONAL SEARCH REPORT
### Information on patent family members

International application No.

**PCT/KR2024/010272**

| Patent document cited in search report | | | Publication date (day/month/year) | Patent family member(s) | | | Publication date (day/month/year) |
|---|---|---|---|---|---|---|---|
| KR | 10-2020-0070649 | A | 18 June 2020 | KR | 10-2543571 | B1 | 15 June 2023 |
| | | | | US | 2020-0185714 | A1 | 11 June 2020 |
| KR | 10-2467486 | B1 | 17 November 2022 | | None | | |
| KR | 10-2023-0038123 | A | 17 March 2023 | CN | 117916202 | A | 19 April 2024 |
| | | | | CN | 117941095 | A | 26 April 2024 |
| | | | | EP | 4379857 | A1 | 05 June 2024 |
| | | | | EP | 4382487 | A1 | 12 June 2024 |
| | | | | JP | 2024-531572 | A | 29 August 2024 |
| | | | | JP | 2024-531582 | A | 29 August 2024 |
| | | | | KR | 10-2023-0038124 | A | 17 March 2023 |
| | | | | US | 2023-0083736 | A1 | 16 March 2023 |
| | | | | WO | 2023-038469 | A1 | 16 March 2023 |
| | | | | WO | 2023-038473 | A1 | 16 March 2023 |
| KR | 10-2019-0139033 | A | 17 December 2019 | CN | 111742431 | A | 02 October 2020 |
| | | | | CN | 111742431 | B | 10 October 2023 |
| | | | | EP | 3742533 | A1 | 25 November 2020 |
| | | | | JP | 2021-514524 | A | 10 June 2021 |
| | | | | JP | 7191342 | B2 | 19 December 2022 |
| | | | | KR | 10-2288292 | B1 | 10 August 2021 |
| | | | | US | 11973209 | B2 | 30 April 2024 |
| | | | | US | 2021-0005875 | A1 | 07 January 2021 |
| | | | | WO | 2019-235885 | A1 | 12 December 2019 |
| KR | 10-2019-0092825 | A | 08 August 2019 | KR | 10-2325728 | B1 | 12 November 2021 |

Form PCT/ISA/210 (patent family annex) (July 2022)

20

**EP 4 734 180 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230097407